Europäisches Patentamt

European Patent Office

Office européen des brevets

(19)

(11) Publication number: **0 286 600**
**A2**

(12)

# EUROPEAN PATENT APPLICATION

(21) Application number: **88830111.6**

(51) Int. Cl.⁴: **H 04 B 1/08**

(22) Date of filing: **18.03.88**

(30) Priority: **10.04.87 IT 2139087    08.02.88 IT 1934288**

(43) Date of publication of application:
**12.10.88  Bulletin  88/41**

(84) Designated Contracting States:
**AT BE CH DE ES FR GB GR LI LU NL SE**

(71) Applicant: **Pallotti, Virgilio**
**Via S. Rosa, 10**
**Lissone Milano  (IT)**

**Pallucchini, Franco**
**Via F.lli Cervi Milano, 2**
**Segrate Milano  (IT)**

(72) Inventor: **Pallotti, Virgilio**
**Via S. Rosa, 10**
**Lissone Milano  (IT)**

**Pallucchini, Franco**
**Via F.lli Cervi Milano, 2**
**Segrate Milano  (IT)**

(74) Representative: **La Ciura, Salvatore**
**Via Francesco Sforza 5**
**I-20122 Milano  (IT)**

(54) A car radio comprising two separable units.

(57) A car radio comprising a fixed base unit (1) having electronic components and circuits contained therein for the reception , detection and amplification of radio waves, and a movable control unit (2) connected to the base unit (1) via an electric cable (2) and arranged to provide for turning on, turning off, tuning, channel preselection, volume control, etc.., the movable control unit (2) being normally fitted to a holder means (22) and being able to be removed and taken away by disconnecting an electric connector element (21) terminating the cable (3), said movable unit (2) further having a cassette player or a television channel receiver enclosed therein.

FIG.2

EP 0 286 600 A2

## Description

### A CAR RADIO COMPRISING TWO SEPARABLE UNITS

This invention relates to a car radio comprising two separable units.

As is known, car radio as commercially available at present, comprise one single operative unit, usually in the form of a parallelepipedon block which contains all of the electronic circuits required for operating the car radio and which carries at the front the different control buttons enabling to perform such functions as switching on, switching off, tuning, volume control, etc.

One disadvantage of these car radio is that, in use, a car radio occupies a fixed position and this position not always is the most convenient position for a driver so that this latter has to divert his attention from driving in order to operate the control buttons.

Another disadvantage is that car radio are more and more frequently an objective aimed at by thiefs who not only take hold thereof but cause also serious damages to a car in doing so.

For this reason, there is a tendency today towards installing car radio of a withdrawable type. However, this means that whenever a driver leaves the car, he has to take the car radio with him, which is rather cumbersome.

The object of this invention is to eliminate the above disadvantages by providing a car radio which is easy to operate by an user driving the car and which is so designed as to entirely prevent any risk of theft.

This object is achieved by a car radio according to this invention which comprises a fixed base unit having electronic components enclosed therein for receiving, detecting and amplifying radio waves, and a movable control unit connected to the base unit via an electric cable and being provided with buttons for inputting all the desired function controls to the car radio.

The fixed unit may be installed at any position in a car, preferably a position out of sight as, for example, behind a dashboart, while the movable control unit may be fitted to the car dashboard, for example , by the aid of a holder means.

The movable control unit has a built-in connector element for coupling with a complementary connector element provided at one end of said connecting cable.

As an alternative to the electric cable connection, the movable and fixed units may be connected via a radio-relay- system arrangement by providing an infrared transmitter on the movable unit and a corresponding receiver on the fixed unit.

The movable control unit may be easily manipulated by a driver and, in case of stopping and leaving the car, this pocket-size unit is readily removed from a vehicle.

On the other hand, the base unit remains at a fixed, concealed position in the car where it is hardly detected by a thief. In any event, because of the base unit being not capable of operating by itself, it is of no commercial utility and, thus, any risk of theft is prevented.

According to a preferred embodiment of the invention, enclosed in the movable control unit is a cassette player or, alternatively, a television channel receiver with associate liquid crystal display. In both cases the movable unit has a door provided in its front panel for access to the cassette receiving space, or for uncovering the display which remains usually in a covered condition.

Further features and advantages of a car radio according to the invention will be better understood from the following detailed description when read with reference to the accompanying drawings showing, by way of example only, preferred embodiments thereof, and in which :

Figure 1 is a perspective view of a base fixed unit of a car radio according to the invention.

Figure 2 is a schematic perspective view of an inner part of a car, showing the movable control unit of a car radio as fitted to a dashboard of the car.

Figure 3 is a perspective view of the movable control unit according to a first embodiment thereof, having a cassette player enclosed therein.

Figure 4, 5 and 6 are a front view, a side view, and a view from the rear, respectively, of the movable control unit in figure 3.

Figure 7 is a perspective view of a movable control unit according to a second embodiment of the invention, wherein the movable unit is arranged to enclose a TV receiver.

Figure 8 is a front view of the movable unit in figure 7.

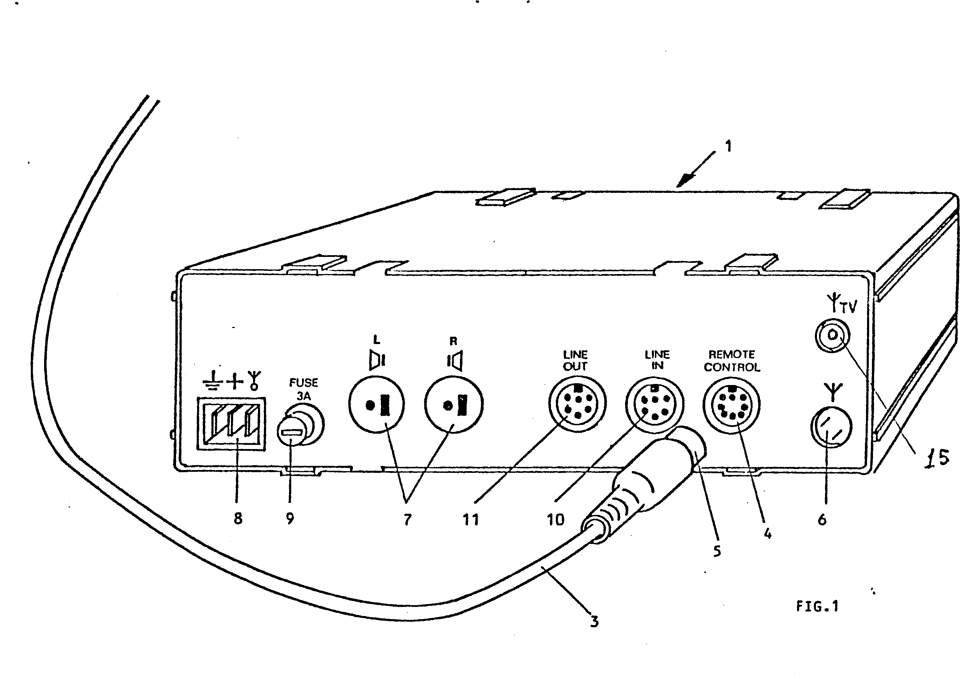

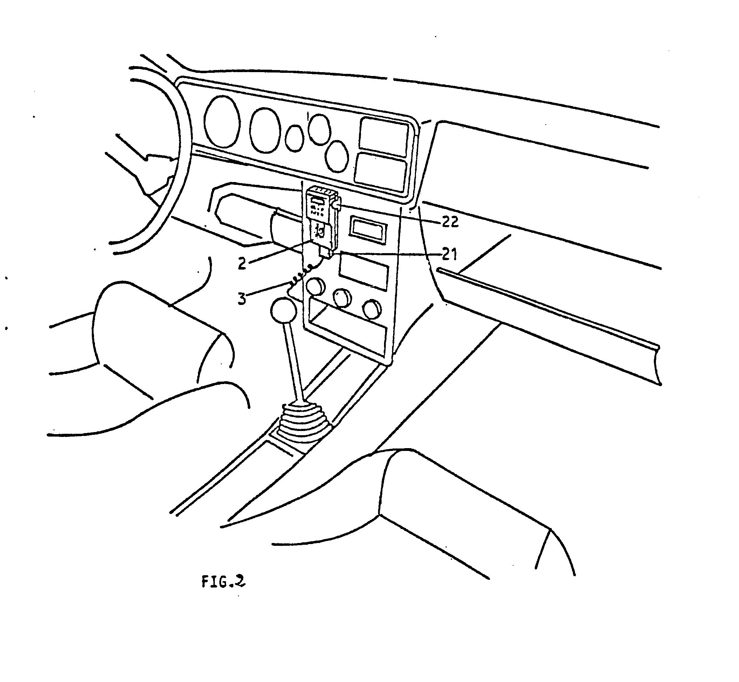

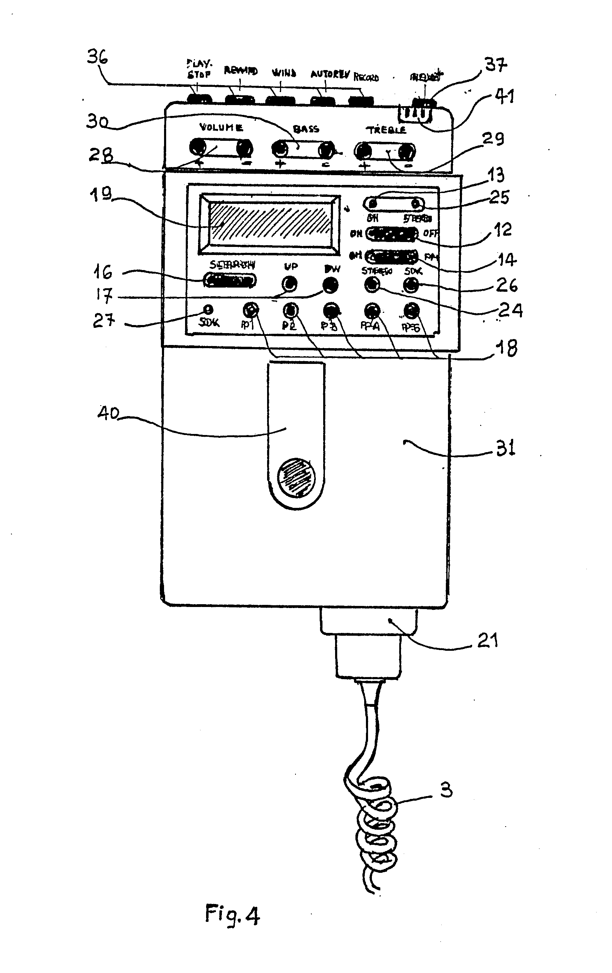

Referring now to the above figures, there is designated by 1 a base unit for a car radio according to this invention (figure 1) and by 2 a control unit (figures 2-8) for the same car radio, the two units being connected to one another via a screened, highly flexible, electric cable 3.

The base unit 1 is a box-shaped unit and enclosed therein are all of the components and electronic circuits for receiving, detecting and amplifying the amplitude and frequency modulated incoming radio waves, as well as for supplying power to auxiliary devices to be discussed later, and for amplifying the signals applied thereto.

The base unit 1 has no control buttons or knobs provided thereon so that it is of no utility by itself.

This base unit 1 has at its front panel a jack 4 for a connector 5 terminating one end of the connecting cable 3, a radio antenna jack 6, possibly a TV antenna jack 15, at least two jacks 7 for connecting a corresponding number of loudspeakers, a jack 8 for supplying power to the car radio, the auxiliary apparatus and an electric antenna, if any, as well as a fuse means 9 which is accessible from the outside for easy replacement.

As stated above, the base unit 1 is arranged for cooperation with auxiliary apparatus such as a cassette player and/or a compact-disc reader. To this end, provided on the front panel of unit 1 is an intake 10 for input signals from a cassette player and/or a compact-disc reader, and a jack 11 for an external amplifier which is necessary when a compact-disc reader is used.

The movable control unit 2 (figures 2-8) functions as the front panel of a conventional car radio. It is of a flattened shape and very reduced in size (e.g. 75 × 125 × 26 mm including protruding parts) so that it can be handled as a pocket-unit, and it carries all of the buttons or knobs that are necessary for controlling the various functions of a car radio.

In particular, the control unit 2 has a ON-OFF switch 12 for switching on and off the car radio, the state of which switch 12 is indicated by a light-emitting diode (LED) 13; a AM/FM band switch 14 for the amplitude or frequency modulation reception; a button 16 for automatic channel selection; two UP-DOWN buttons 17 for discrete change of tuning; five buttons 18 for amplitude modulation and frequency modulation pretuning of a corresponding number of channels; a FM stereo station inputting-suppressing button 24 and associate state indicating LED 25; A SDK button 26 for inputting a pretuned station transmitting vehicular traffic information and associate state indicating LED 27; three buttons 28, 29, 30 for volume, high tone and low tone control, respectively.

The control unit 2 further has a bright display 19 on which an indication of a tuned frequency appears.

The control unit 2 has on a rear part and at a lower edge thereof, a flush mounted electric connector element for cooperating with a complementary element 21 carried at a corresponding end of the connecting cable 3 to provide for electrical connection between the control unit 2 and the base unit 1.

Instead of an electric cable, use may be made od a radio relay system for establishing connection between the movable unit 2 and the fixed unit 1. In this case, a transmitter, for example, an infrared transmitter is provided on the movable unit 2 and a corresponding receiver on the fixed unit 1.

Provided in the sidewalls of control unit 2 are two grooved guides 20 for rapid fitting of the control unit to a holder means 22 which has, to this end, two holding members 23 for engagement with the corresponding guide grooves 20. The holder means 22 may be fastened, for example, by adhesive means, or by the aid of screws, to a dashboard of an automobile or motor vehicle, as shown figure 2, which figure also shows the control unit 2 when fitted in place.

The fixed unit 1 is, on the other hand, preferably located at a point in a car which is difficult of acces as, for example, behind a dashboard.

With a car radio according to this invention, when a driver desires to listen to the radio, he can take the movable control unit 2 and manipulate it with ease without diverting his attention from driving.

In case of leaving the car for a halt, it is sufficient, in order to prevent any theft, to disconnect the connector element 21 terminanting the connecting cable 3 and then remove the control unit 2 which is a pocket-sized unit.

When a radio-relay-system connection is provided between the movable unit 2 and the fixed unit 1, it is of course sufficient to disengage the movable unit 2 from the holder means 22 to enable the movable unit 2 to be taken off.

What stated above broadly applies to whatever embodiment of the movable control unit 2 as such.

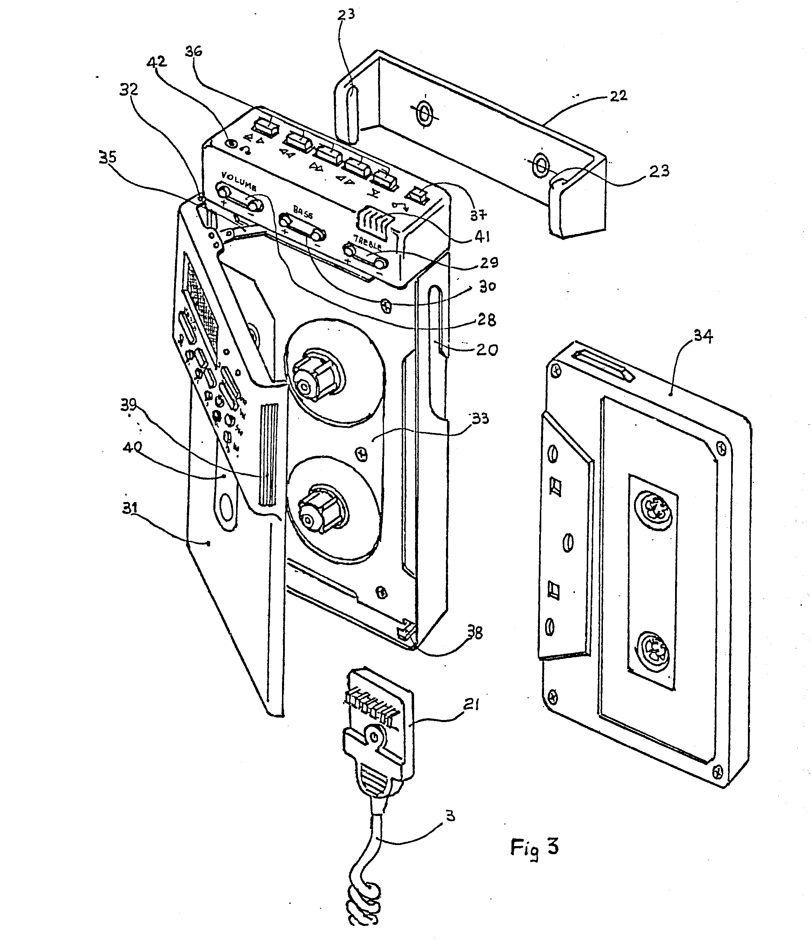

Embodiments of a movable unit 2 having a cassette player or a television channel receiver enclosed therein will now be described in detail with reference to figures 3 to 6 and figures 7 and 8 respectively, of the accompanying drawings.

Referring to figure 3 to 6, first the movable unit 2 including a cassette player, will be described.

Provided at the front of movable unit 2 is an openable door 31 extending over almost the entire front wall of the movable unit to permit access to an inner space 33 arranged to receive a magnetic cassette 34 (see figure 3).

The door 31 is attached to the movable unit 2 by a lateral hinge 32 and a guide strap 35 that serves also as a support for retaining the door 31 in its open position, as viewed in fig. 3.

Operating controls for use of the cassette player, are generally designated by reference numeral 36 and are carried on the top wall of the movable unit 2; said top wall also has button 37 located thereon for operating an inner safety hook 38 which permits snap-opening of the door 31, this latter being laterally provided with a knurling formation 39 to assist in easily opening the door.

The general controls for utilization of the radio set as such, are, in this case, located at an upper part of the door 31, which upper part is slightly jutting out with respect to the rest of door 31 with a transparent window 40 being provided in said door upper part for checking the presence of a cassette 34 within the cassette receiving space 33.

The buttons 28, 29, 30 for control of preamplified sound are **utilized** by the radio set and the cassette player in common.

Finally, the movable unit 2 has a microphone 41 and a headphone jack 42 to enable the movable unit 2 to be used as a cassette player and recorder even when it is disconnected from the unit 1. To this end, the movable unit 2 may be equipped with a rechargeable battery, not shown in the accompanying drawings.

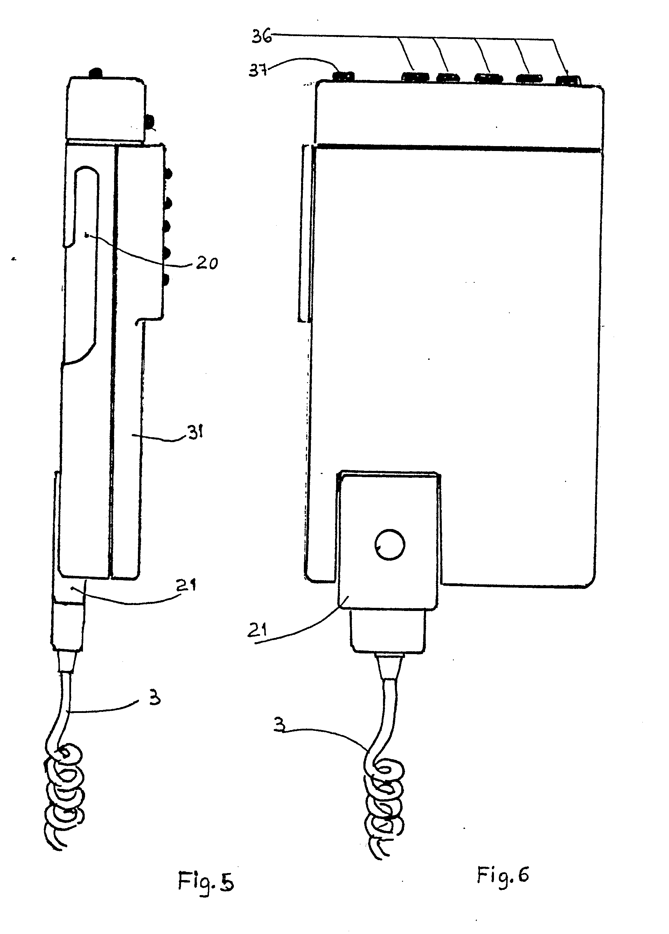

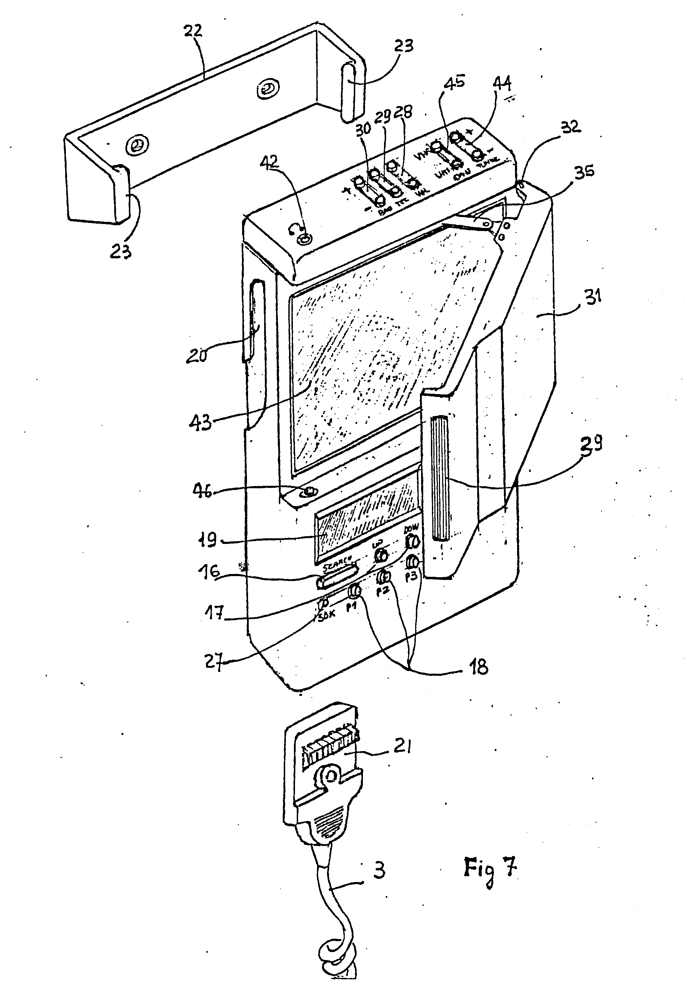

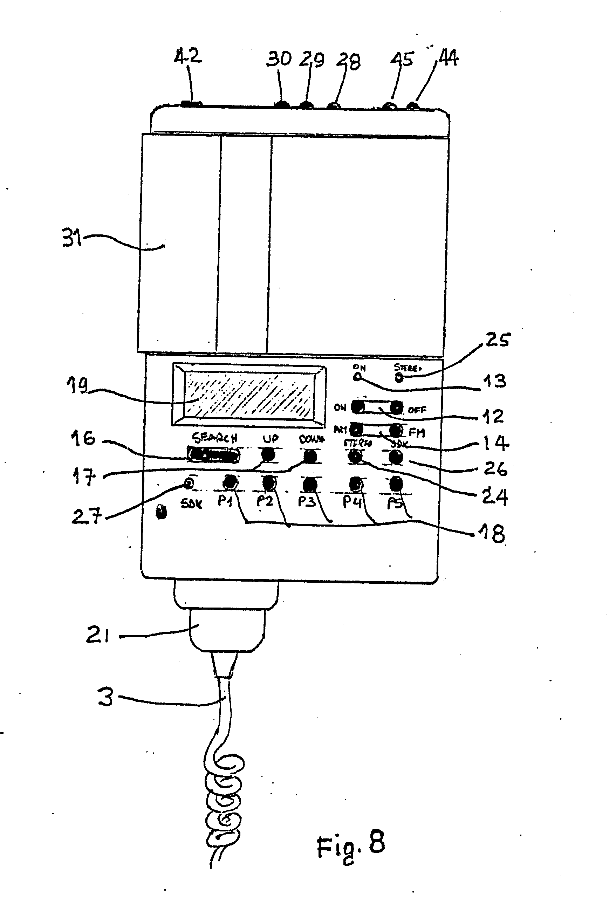

Now, a movable unit 2 including a television channel receiver will be described in relation to figures 7 and 8, in which the same reference numerals as used in figures 3 and 6 designate equal, or substantially equal parts.

In this case too, the movable unit 2 has at the front thereof a deflecting door 31 attached to said unit by means of a lateral hinge 32 and a support and guide strap 35. The door 31 extends over about the front-wall upper half of the movable unit 2 to normally cover an abt. 2.5 in. liquid crystal screen 43.

The door 31, which can be internally lighted up in order to enable viewing of the liquid crystal screen 43 when in a dark condition, is especially provided to prevent the driver's attention from being diverted during driving; this also because in almost all of the world countries, authorities explicitly forbid drivers to look at TV programs during driving, owing to safety reasons, as a matter of fact.

Thus, due to the cover 31, a driver is obliged to stop the car and to take and hold the movable unit 2 by both his hands in order to be able to discover the screen 43.

The embodiment of a movable unit 2 enclosing a television channel receiver, is important in that it permits useful information, such as a map of a town where a driver is running, to be received and displayed on the screen 43.

According to this embodiment, the general control means for using the radio set, are located in a bottom part of the front wall of movable unit 2, which bottom part is occupied by no door 31, while the top of the movable unit 2 carries the control buttons for the television receiver, namely a button 44 for tuning control and a button 45 for selecting the VHF and UHF bands of frequency.

For the radio/TV switching, a dog or pawl-shaped switch 46 is provided and is operated on opening and closing the door 31.

Here again, the buttons 28, 29, 30 on the top wall of the movable unit 2 are commonly utilized by both the radio set and the television receiver and are selectively acted upon according to what is the particular end to which the movable unit 2 is, at that time, employed.

Finally, in this embodiment too, a headphone jack 42 is provided, and is intended for permitting a headphone to be used in hearing the sound when it is desired to utilize the movable unit 2 as a television receiver, disconnected from the base unit 1. For the utilization as a self-contained television receiver, the movable unit 2 should be equipped with a rechargeable battery, not shown in the drawings.

The embodiment of the movable unit 2 enclosing a cassette player ( figures 3-6),or a television receiver (figures 7,8), as compared with a solution of providing said auxiliary sets as separate units connected to the base unit 1, is preferred not only from a space saving point of view, but also because of these sets being selectively enclosed within the movable unit 2, they can be removed and carried away along with the movable unit itself when leaving a car.

Though specified embodiments of this invention have been described herein before and shown by way of examples in the accompanying drawings, it should be apparent that many modifications and variations may be made thereto as to the details of construction, without departing from the scope of the invention.

**Claims**

1. A car radio comprising a fixed base unit (1) having electronic components and circuits contained therein for receiving, detecting and amplifying radio waves, as well as for supplying power to possible auxiliary devices and amplifying the signals applied thereto, but having no control buttons provided on it, and a movable control unit (2) which can be connected to the base unit (1) via an electric cable (3) or through a radio-relay-system arrangement, the movable unit (2) being provided with buttons and/or indicating means (12-14, 16-19, 24-30) for inputting all of the desired control signals to the car radio and/or for signalling the state of the different functions.

2. The car radio according to claim 1, wherein the movable control unit (2) has grooved guides (20) formed in both sidewalls thereof, said guide grooves (20) being engageable by corresponding retaining members (22) formed on a holder (22) so as to permit the control unit (2) to be quickly fitted to the holder (22) which latter is arranged to be fastened, for example, to a dashboard in a motor vehicle, by adhesive means or by the aid of screws or the like.

3. The car radio according to claim 1 or claim 2, wherein said movable control unit (2) encloses a cassette player/recorder, or a television receiver, and provided on said movable control unit (2) are control buttons (36-37) for controlling a cassette player/ recorder, or control buttons (44-45) for controlling a television receiver.

4. The car radio according to claim 3, wherein the movable unit (2) has at its front a door (31) arranged to cover a cassette receiving space (33) or to cover a television liquid crystal screen (43), said door (31) being attached to the movable unit (2) by means of a lateral hinge (32) and a guide and support strap (35).

5. The car radio according to claim 3 or claim 4, wherein provided on said movable unit (2) are sound control buttons (28, 29 and 30) which are common to the radio set and a cassette player/recorder, or which are common to the radio set and a television receiver.

6. The car radio according to any of the claims 3 to 5, wherein the movable unit (2) has a headphone jack (42) and is equipped with a rechargeable battery to permit the movable control unit (2) to be used as a self-contained cassette player/recorder device or as a self-contained television receiver device.

0286600

FIG.1

REMOTE CONTROL

LINE IN

LINE OUT

TV

R

L

FUSE 3A

0286600

FIG.2

0286600

Fig 3

Fig. 4

0286600

Fig. 5

Fig. 6

36

37

20

31

21

3

21

3

0286600

Fig 7

0286600

Fig. 8